(19)

Europäisches
Patentamt
European
Patent Office
Office européen
des brevets

(11) EP 1 986 363 A1

(12) EUROPEAN PATENT APPLICATION

(43) Date of publication:
29.10.2008 Bulletin 2008/44

(51) Int Cl.:
H04L 1/00 (2006.01)     H03M 13/09 (2006.01)

(21) Application number: 07290521.9

(22) Date of filing: 25.04.2007

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(71) Applicant: Alcatel Lucent
75008 Paris (FR)

(72) Inventors:
• Costantini, Carlo
22064 Casatenovo (Lecco) (IT)

• Ronchetti, Luigi
22100 Como (IT)
• Cucchi, Silvio
20083 Gaggiano(Milano) (IT)

(74) Representative: Colombo, Stefano Paolo
MARCHI & PARTNERS S.r.l.
Via G.B. Pirelli, 19
20124 Milano (IT)

Remarks:
Amended claims in accordance with Rule 137(2)
EPC.

(54) **Method, device and network element for decoding an information word from a coded word**

(57)     It is disclosed a method for decoding an information word from a set of coded words. The method comprises the steps of receiving a coded word, of selecting a coded word having the minimum distance from the received coded word from a pre-configured sub-set of the set of the coded words, wherein the sub-set is configured to at least two coded words having each other a distance higher than the minimum distance between the coded words of the set, and of decoding the information word from the selected coded word.

Fig.6

## Description

FIELD OF THE INVENTION

The present invention generally relates to a method for decoding an information word from a coded word. More specifically, the present invention concerns a device using the method and to a network element for telecommunications networks including the device.

BACKGROUND OF THE INVENTION

In the field of telecommunications networks, coding and decoding of information to be first transmitted and after received is known. A lot of research was carried out in the past on coding anddecoding algorithms and methods aimed at detecting and/or correcting errors. In different environments, different coding and decoding algorithms and methods are useful or necessary.

As it is known, GFP [Generic Framing Procedure] provides a generic mechanism to adapt traffic from higher-layer client signals over a transport network. Client signals may be PDU-oriented (such as IP/PPP or Ethernet MAC) or block-code oriented constant bit rate stream (such as Fibre Channel or ESCON/SBCON).

GFP was defined by the International Telecommunication Union (ITU) in ITU-T G.7041/Y.1303 (08/2005). This recommendation defines a generic framing procedure to encapsulate variable length payload of various client signals for subsequent transport over SDH, PDH or OTN networks and includes:

- the frame formats for protocol data units [PDU] transferred between GFP source and destination points, and
- the procedure for mapping the client signals into GFP frames.

The framing procedure described in this recommendation can be applied to both the encapsulation of entire client frames (frame mapped GFP), in which a single client frame is mapped into a single GFP frame, and to character mapped transport (transparent GFP) in which a number of client data characters are mapped into efficient block codes for transport within a GFP frame.

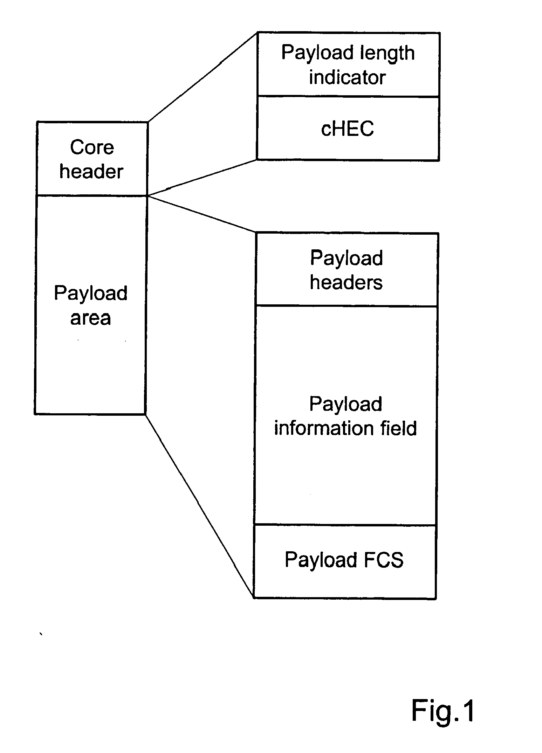

The format for GFP frames is shown in enclosed Fig.1. GFP frames are byte-aligned and consist of a Core header field and (except for GFP Idle frames) a Payload area.

The Core header consists of four bytes corresponding to a 16-bit Payload length indicator [PLI] field and a 16-bit core Header Error Check [cHEC] field. The Core header allows GFP frame delineation independent on the content of the higher layer PDUs.

The two-bytes PLI field includes a binary number representing the number of bytes in the Payload area. The absolute minimum value of the PLI field in a GFP client frame is 4 bytes. PLI values 0-3 are reserved for GFP control frame usage.

The two-bytes core Header Error Control field includes a CRC-16 error control code that protects the integrity of the contents of the Core header by enabling both single-bit error correction and multi-bit error detection. The value of the core Header Error Check field is calculated taking into account the bytes of the Core header as defined in the above mentioned standard. Additionally, the Core header is scrambled as defined in the above mentioned standard.

The Payload area, which consists of the bytes in the GFP frame after the Core header, is used to carry higher layer specific protocol information. This variable length area may include from 4 to 65535 bytes.

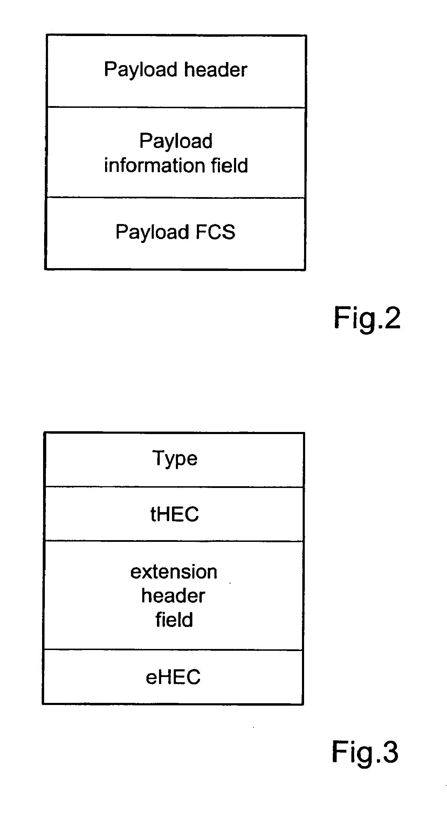

Fig.2 shows more in detail the structure of the Payload area, which includes two mandatory fields: a Payload header and a Payload information field. An optional Payload FCS field is also supported. The Payload header is a variable-length area, 4 to 64 bytes long, intended to support data link management procedures specific to the higher-layer client signal.

Fig.3 shows more in detail the structure of the Payload header, including two mandatory fields, the Type field and the type Header Error Check (tHEC) field; the Payload header further includes a variable number of additional payload header fields, the extension header field and the extension Header Error Check (eHEC). The presence of the extension header, and its format, and the presence of the optional Payload FCS depend on the content of the Type field. The Type field indicates the content and format of the Payload information field. The two-bytes type Header Error Check field includes a CRC-16 error control code which protects the integrity of the contents of the Type field by enabling both single-bit error correction and multi-bit error detection. The contents of the type Header Error Check field is generated basically using the same steps as the core Header Error Check field. The extension header field is a 0 to 60 bytes long and it's it's protected by the two-bytes extension Header Error Check [eHEC] field.

The payload header for a frame with a Null Extension Header applies to a logical point-to-point configuration. It is intended for scenarios where the transport path is dedicated to one client signal.

At the reception side the GFP sink adaptation process shall perform single-bit error correction on the Type field, which is protected by the type Header Error Check field. The GFP sink adaptation process shall discard any of those GFP frames where multi-bit errors are detected.

The Payload Information field includes the framed PDU for frame mapped GFP or, in the case of transparent GFP, a group of client signal characters. This variable length field may include from 0 to 65535-X bytes, where X is the size of the Payload Header. This field may include an optional Payload FCS field. The client PDU/ signal is mapped into the Payload information field as an byte-aligned packet stream.

The Payload FCS is an optional, four-byte long, Frame Check Sequence. It includes a CRC-32 sequence that protects the contents of the Payload information field. The Payload FCS is generated as defined in the above mentioned standard.

According to the above mentioned standard, scrambling of the Payload area is required and is carried out according to a defined scrambling method.

Two types of GFP client frames are currently defined: Client Data frames and Client Management frames. Client Data frames are used to transport data from the client signal. Client Management frames are used to transport information associated with the management of the client signal or GFP connection. Both Client Data frames and Client Management frames are GFP client frames consisting of a Core header and a Payload Area. The content of the Type field is defined by the above mentioned standard.

GFP control frames are used in the management of the GFP connection. The only control frame specified at this time is the GFP Idle frame. The GFP Idle frame is a special four-byte GFP control frame consisting of only a Core header with the PLI and core Header Error Check fields set to 0 and no Payload Area. The Idle frame is intended e.g. for use as a filler frame for the GFP source adaptation process to facilitate the adaptation of the GFP byte stream to any given transport medium where the transport medium channel has a higher capacity than required by the client signal. Control frames with PLI = 1, 2 or 3 are for further and future study.

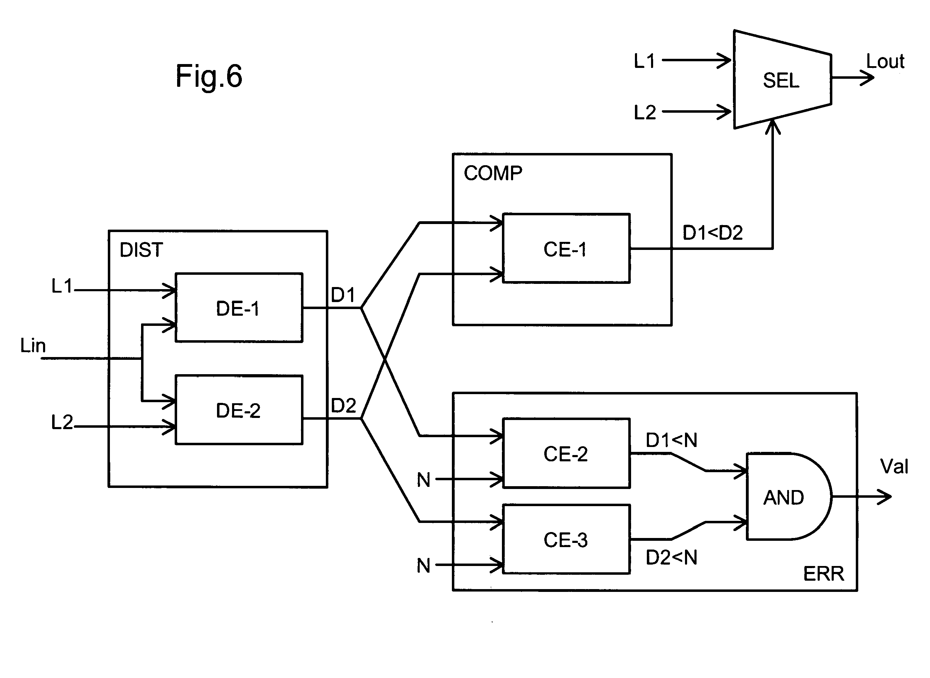

GFP frame delineation is performed based on the correlation between the first two bytes of the GFP frame, i.e. the PLI field of the Core header, and the two-byte core Header Error Check field. The above mentioned standard specifies the frame delineation method and a state diagram (see Figure 6-13 of the above mentioned standard) for implementing it.

Basically three states are defined:

- HUNT, when the receiver has not yet identified the beginning of a frame (error correction on the Core header is disabled),
- PRESYNC, when the receiver has identified the beginning of only one (or few) frames (error correction on the Core header is disabled), and
- SYNC, when synchronism is considered reliably reached (error correction on the Core header is enabled. i.e. single-error correction).

Typical transitions are:

- from HUNT to PRESYNC, and
- from PRESYNC to SYNC.

If multiple bit errors are detected in the Core header when in the SYNC state, a state transition from the SYNC state to the HUNT state occurs.
As already said, GFP specifies also the encapsulation aspect, in particular the adaptation of client signals using a frame-by-frame mapping of different client signals, including Digital Video Broadcasting [DVB] standard. The data in the DVB standard is transmitted in Transport Stream [TS] packets; the format of the TS packets is defined by ETSI [European Telecommunication Standard Institute] as either 188 bytes or 204 bytes, the latter being referred to as Reed-Solomon [RS] coded TS packets. There is a one-to-one mapping between a TS packet (either RS coded or not) and a GFP PDU.

SUMMARY OF THE INVENTION

When data packets are mapped into GFP frames and are transmitted over a noisy medium, e.g. a radio link, the GFP mechanism reveals not to be very robust, in particular it is not robust enough against bursts of errors. In fact, the Core header of the GFP frame is coded (according to the above mentioned standard) in such a way as to enable the correction of a single-bit error in the Core header and, when more than a single-bit error occurs in the Core header of the GFP frame, the frame delineation state machine goes unlocked and a number of GFP frames (and therefore client data) are lost.
A similar problem may arise in other situations (e.g. information transport protocols different from GFP) where a code to be used for coding the whole or a part of a data packet was designed for a certain telecommunication environment and then it is or must be used in a different telecommunication environment more demanding in terms of error detection and/or correction.
It is the general object of the present invention to overcome the drawbacks of the prior art and in particular to use a code in a telecommunication environment more demanding than originally expected in terms of error detection and/or correction.
It is a specific object of the present invention to reliably use GFP for a noisy medium, in particular a radio link.
These and other objects are achieved through the decoding method, the device and the network element having the features set out in the enclosed claims.
The basic idea behind the present invention is to use only a sub-set (typically a small sub-set) of possible coded words at the transmission side and to take advantage of this at the reception side when decoding the received coded word. In this way, a number of errors can be detected and/or corrected higher than the number provided for by the code used for coding data.
Advantageously, this method is applied only to one or few of the fields of the received data packet; in particular, this field indicates the length of the whole or part of the data packet. In this way, no severe limitations are introduced to transmitted data packets at the transmission side.
This method can be advantageously applied to GFP, in particular to the Core header of the GFP frame, i.e. to the payload length indicator that is essential for frame delineation.

According to certain advantageous embodiments, this method implies that only one or few kinds of traffic are carried by the data packets, in particular video data traffic, compressed or not compressed.

Preferably, this method may be applied to video data traffic for broadcasting or point-to-point transmission.

According to a first aspect, the present invention provides a method for decoding an information word from a set of coded words. The method comprises the steps of receiving a coded word, of selecting a coded word having the minimum distance from the received coded word from a pre-configured sub-set of the set of the coded words, wherein the sub-set is configured to at least two coded words having each other a distance higher than the minimum distance between the coded words of the set, and of decoding the information word from the selected coded word.

Preferably, the step of receiving the coded word includes the steps of receiving a data packet, the data packet including an header field carrying the received coded word and including a payload field, the received coded word indicating the coded length of the payload field of the received data packet, and of extracting the coded word from the received data packet.

Preferably, the payload field carries a video signal.

Preferably, said sub-set consists of two coded words.

Preferably, the method further includes the step of generating a signal indicating if the decoded information word is valid.

Preferably, one of the two coded words of the sub-set indicates that the data packet has a zero-length payload and the other of the two coded words of the sub-set indicates the coded length of the payload field carrying the video signal.

Preferably, the received data packet further includes another header field carrying another coded word indicating that the type of the payload field is the video signal, wherein the other header field is configured to the type indicating the video signal. The method further including the steps of extracting the other coded word from the received data packet, of detecting the number of errors affecting the other received coded word, of discarding the other received coded word in case the number of errors is greater than a pre-defined number, and of assigning the other header field to the configured type indicating the video signal.

Preferably, the received data packet is arranged into a Generic Framing Procedure frame and wherein the received coded word is the core header of the received GFP frame.

Preferably, the other header field is the payload header of the Generic Framing Procedure frame.

Preferably, the data packet is receveid from a radio link.

According to a second aspect, the present invention provides a device to decode an information word from a set of coded words. The device includes first means for configuring a sub-set of the set of the coded words to at least two coded words having each other a distance higher than the minimum distance between the coded words of the set and includes second means for selecting from the configured sub-set a coded word having the minimum distance from a received coded word and for decoding the information word from the selected coded word.

Preferably, the second means include a first sub-circuit for calculating the distances between the received coded word and the at least two coded words of the configured sub-set, a second sub-circuit for comparing each other the calculated distances, and a third sub-circuit for selecting from the at least two coded words the coded word having the minimum calculated distance.

Preferably, the device further including third means for comparing the calculated distances respect to a pre-determined distance, in case at least one of the calculated distances is greater than the pre-determined distance for generating a signal for indicating that the decoded information word is not valid, in case the calculated distances are smaller or equal to the pre-determined distance for generating the signal (Val) for indicating that the decoded information word is valid.

Preferably, the payload field carries a video signal.

Preferably, the sub-set consists of two coded words.

According to a third aspect, the present invention provides a network element including processing means adapted to receive a data packet, the processing means including a device according to the second aspect, the data packet including an header field carrying the received coded word and including a payload field, the received coded word indicating the coded length of the payload field of the received data packet, wherein the processing module is further adapted to extract the coded word from the received data packet.

According to a fourth aspect, the present invention provides a computer program comprising computer program code means adapted to perform all the steps of the method according to the first aspect when the program is run on a hardware of a network element.

BRIEF DESCRIPTION OF THE DRAWINGS

The present invention will become more clear from the following description to be considered in conjunction with the enclosed drawings, wherein:

- Figure 1 shows the format of a GFP frame;
- Figure 2 shows the format of a Payload area of the GFP frame;
- Figure 3 shows the format of a Payload header of the GFP frame;

- Figure 4 shows a a telecommunications network according to the present invention;
- Figure 5 shows a simplified block diagram of a network element according to the present invention;
- Figure 6 shows a schematic block diagram of a device according to the present invention.

It is to be understood that the following description and the enclosed drawings are not to be interpreted as limitations of the present invention but simply as exemplifications.

BEST MODE FOR CARRYING OUT THE INVENTION

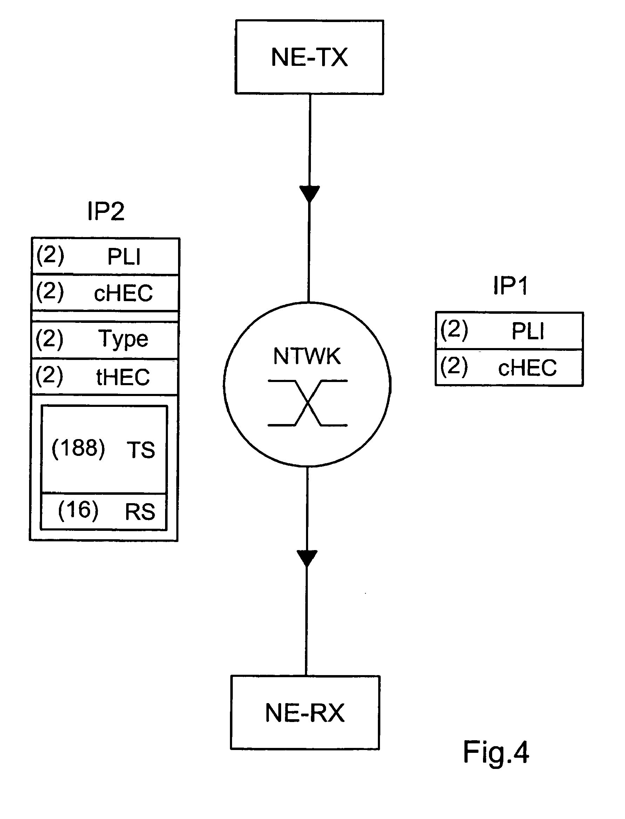

Fig.4 shows a telecommunications network, in particular an SDH telecommunications network.

In Fig.4, only two network elements NE-TX and NX-RX are shown and are interconnected through part of the telecommunications network NTWK, even if many other network elements can be present in NTWK.

In the following, the present invention will be described with reference to the following particular situation (which is anyway quite typical for an application of the present invention):

- network element NE-TX transmits data packets and network element NE-RX receives these data packets,
- network element NE-TX and NE-RX are connected together through a radio link,
- the data packets carry a video signal in a compressed digital format,
- the data packets are encapsulated into GFP frames.

It is also assumed that only two types of GFP frames will be encapsulated into SDH frames, transmitted by network element NE-TX, received by network element NE-RX and decapsulated: a first type IP1 of GFP frames and a second type IP2 of GFP frames, which are shown in Fig.4.

First type frames IP1 are "idle frames", i.e. GFP control frames used for management of the GFP connection. Such frames have no payload area (in other terms zero-length payload area) and only the Core header which is composed of four bytes, two bytes for the payload length indicator [PLI] field and two bytes for the core Header Error Check field.

Second type frames IP2 are GFP frames carrying the video data. Such frames have both the Core header and the payload area; the Core header is composed of four bytes, two bytes for the payload length indicator [PLI] field and two bytes for the core Header Error Check field; the Payload area is composed of 208 bytes, including two bytes for the Type field of the payload header, two bytes for the type Header Error Check field of the payload header, 188 bytes for the Transport Stream [TS] data of the payload information field and 16 bytes for the Reed-Solomon [RS] data of the payload information field.

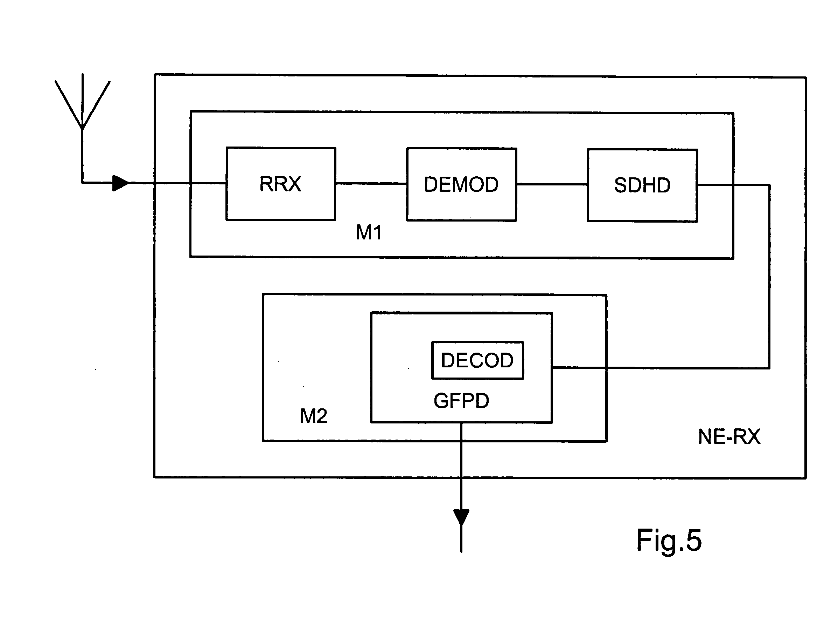

Referring to Fig.5, network element NE-RX receives SDH frames carrying GFP frames including RS coded TS packets carried by a radio signal from an antenna; the radio signal is provided to a receiving module M1 which outputs a sequence of GFP frames to a processing module M2; processing module M2 receives the GFP frames and outputs a video signal.

Receiving module M1 comprises a radio receiver RRX connected to the input of module M1 and therefore to the antenna, a demodulator DEMOD connected to the output of radio receiver RRX, and an SDH deframer SDHD connected to the output of demodulator DEMOD; the output of module M1 is connected to the output of deframer SDHD.

Processing module M2 comprises a GFP deframer GFPD having the input connected to the input of module M1 and having the output connected to the output of module M2. Deframer GFPD is adapted to process GFP frames and in particular the two mentioned types IP1 and IP2 of GFP frames; to this purpose, it comprises (among other electronic circuits) a device DECOD, also indicated with decoder.

Device DECOD is adapted to decode the Core header (i.e. combination of the PLI field and the core Header Error Check field) of the GFP frames. Such decoding serves for identifying the length of the various GFP frames received by deframer GFPD.

According to the particular situation considered in this embodiment, only two lengths are possible: zero (corresponding to frame type IP1) and 208 (corresponding to frame type IP2). Anyway, due to transmission errors e.g. over the radio link, received GFP frames may appear to have several lengths which does not correspond to the actually transmitted GFP frames.

Figure 6 shows a schematic block diagram of device DECOD. Device DECOD receives as input a coded word "Lin" corresponding to the Core header of a received GFP frame, i.e. four bytes (32 bits) indicating the length of the payload area of the frame, i.e. the PLI field, and an error control field for protecting the integrity of the content of the Core header, i.e. the core Header Error Check field.

If no assumption is made on the possible values of the PLI field (i.e. any kind of GFP frame can be received and processed), according to the core Header Error Check field and its standardized code, it is possible to correct only 1-bit error in the PLI field and to detect multiple errors.

On the contrary, the present invention makes an assumption on the possible values of the PLI field (that is on the possible lengths of the received GFP frames). In particular, the present embodiment assumes that are managed only GFP frames having a payload with length equal to zero bytes and GFP frames having a payload with length equal to 208 bytes.

Preferably, the present embodiment assumes that that only one kind of data traffic is managed, i.e. length=0 corresponds to an idle frame and length=208 corresponds to video data frame.

The code used in the present embodiment is the usual and standardized code; in this way, no compatibility problems exist between the network element at the transmitting side and the network element at the receiving side. In this case, the Core header for length=0 and the Core header for length=208 differ by 14 bits (i.e. 14-bit distance) and therefore it is possible to correct 6-bit errors in a 32-bit word. In fact, the correcting power is given by the following formula:

$$P = D/2 - 1$$

wherein P is the correcting power and D is the minimum distance (in terms of bits) between the various coded words.

Device DECOD transmits as output a coded word "Lout" indicating the coded length (in terms of bytes) of the received GFP frame.

Preferably, device DECOD also generates as output a logic value "Val" (i.e. 1/0 or true/false) indicating whether the output coded word "Lout" is to be considered valid or not; this concept will be better clarified in the following and is to be considered only an optional and advantageous feature of the present invention.

Device DECOD comprises :

- a sub-circuit DIST for calculating two distances D1 and D2 between the received coded word Lin and two predetermined coded words L1 and L2 respectively corresponding to coded length equal to zero and coded length equal to 208 respectively;
- a sub-circuit COMP for calculating a relative comparison between calculated distances D1 and D2; and
- a sub-circuit SEL for selecting the corrected coded word Lout (to be output) based on said calculated relative comparison.

Additionally and optionally, device DECOD further comprises a sub-circuit ERR for calculating a threshold comparison of the calculated distances D1 and D2 with a predetermined distance N and for issuing a validity signal Val based the such threshold comparison, the validity signal Val indicating whether the selected coded word Lout is valid.

Sub-circuit DIST comprises a first distance calculator DE-1 and a second distance calculator DE-2; calculator DE-1 receives as inputs words Lin and L1, calculates and outputs the distance D1 between the received coded word Lin and coded word L1; calculator DE-2 receives as inputs words Lin and L2, calculates and outputs the distance D1 between the received coded word Lin and coded word L2.

Sub-circuit COMP comprises a first comparator CE-1 that receives as inputs the distances D 1 and D2, calculates and outputs the comparison "D1<D2" (a logic value, i.e. 1/0 or true/false) between the distances D1 and D2.

Sub-circuit SEL comprises a selector that receives as inputs the coded words L1 and L2 and as control input comparison "D1<D2"; the selector outputs L1 if comparison "D1<D2" is "true" and L2 if comparison "D1<D2" is "false".

Sub-circuit ERR comprises a second comparator CE-2, a third comparator CE-3 and an AND gate. Comparator CE-2 receives as inputs the distance D1 and the pre-determined distance N, calculates and generates the comparison "D1<N" (a logic value, i.e. 0/ 1 or true/ false) between distance D1 and pre-determined distance N. Comparator CE-3 receives as inputs the distance D2 and the pre-determined distance N , calculates and generates the comparison "D2<N" (a logic value, i.e. 1/0 or true/false) between distance D2 and the pre-determined distance N. Gate AND generates the logic value Val being the and logic operation between comparison "D1<N" and comparison "D2<N".

The function of sub-circuit ERR is to check if the received coded length has not too many errors. In the above example, preferably it may be decided that, even if it would be possible to correct up to six bits in the received 32-bit coded word, the device signals an "error condition" if more than four bits are erroneous.

The method for decoding according to the invention can be advantageously implemented in a network element of a telecommunication network, like an SDH network, a Sonet network or an OTN network.

The method is implemented in the network element on an hardware device, like into part of an Application Specific Integrated Circuit (ASIC), a Field Programmable Gate Array (FPGA), an Electrically Programmable Logical Device (EPLD) or through a microprocessor.

The method according to the invention can be advantageously implemented through a software program like VHDL (Very High speed integrated circuit Description Language), mapped into an ASIC, FPGA or EPLD; alternatevely, the method according to the invention can be advantageously implemented thorugh a software program (like C) running on a microprocessor.

In case the method is implemented into an ASIC, FPGA or EPLD, the sub-set of the set of coded words is configured by writing statically the values of the coded words of the sub-set into the ASIC, FPGA or EPLD; alternatevely, the sub-set is configured before the startup (that is, before the ASIC, FPGA or EPLD is working for the first time) of the ASIC, FPGA or EPLD, by writing the values of the coded words of the sub-set into registers of the ASIC, FPGA or EPLD. In this case the first means for configuring the sub-set are part of the ASIC, FPGA or EPLD and the registers of the ASIC, FGPA or EPLD store the values of the coded words of the sub-set.

In case the method is implemented through a microprocessor, the sub-set is configured before the startup of the microprocessor, by writing the values of the coded words of the sub-set into registers which are read by the microprocessor. In this case the first means for configuring the sub-set is the microprocessor and the registers of the microprocessor store the values of the coded words of the sub-set.

**Claims**

1. Method for decoding an information word from a set of coded words, the method comprising the step of receiving a coded word (Lin), **characterized in that** the method further comprises the steps of:

 - selecting (DIST, COMP, SEL) a coded word (Lout) having the minimum distance (D 1, D2) from the received coded word (Lin) from a pre-configured sub-set of the set of the coded words, wherein the sub-set is configured to at least two coded words (L1, L2) having each other a distance higher than the minimum distance between the coded words of the set;
 - decoding the information word from the selected coded word.

2. Method according to claim 1, wherein the step of receiving the coded word includes the steps of:

 - receiving a data packet (IP1, IP2), the data packet including an header field (Core header, PLI, cHEC) carrying the received coded word and including a payload field (Payload area), the received coded word indicating the coded length of the payload field of the received data packet;
 - extracting the coded word from the received data packet.

3. Method according to claim 2, wherein the payload field carries a video signal.

4. Method according to any of the previous claims, wherein the sub-set consists of two coded words.

5. Method according to any of the previous claims, further including the step of generating a signal (Val) indicating if the decoded information word is valid.

6. Method according to claims 4 or 5 when dependent on claim 3, wherein one (L1) of the two coded words of the sub-set indicates that the data packet (IP1) has a zero-length payload and the other (L2) of the two coded words of the sub-set indicates the coded length of the paylod field carrying the video signal.

7. Method according to any of claims 3 to 6, wherein the received data packet further includes another header field (Payload header, Type, tHEC) carrying another coded word indicating that the type of the payload field is the video signal, wherein the other header field is configured to the type indicating the video signal, the method further including the steps of:

 - extracting the other coded word from the received data packet;
 - detecting the number of errors affecting the other received coded word;
 - discarding the other received coded word in case the number of errors is greater than a pre-defined number;
 - assigning the other header field to the configured type indicating the video signal.

8. Method according to any of the previous claims, wherein the received data packet (IP1,IP2) is arranged into a Generic Framing Procedure frame and wherein the received coded word is the core header of the received GFP frame.

9. Method according to claim 8, wherein the other header field is the payload header of the Generic Framing Procedure frame.

10. Method according to any of claims 2 to 9, wherein the data packet is receveid from a radio link.

11. Device (DECOD) to decode an information word from a set of coded words, the device including:

 - first means for configuring a sub-set of the set of the coded words to at least two coded words (L1, L2) having each other a distance higher than the minimum distance between the coded words of the set;
 - second means (DIST, COMP, SEL) for selecting from the configured sub-set a coded word (Lout) having the minimum distance from a received coded word (Lin) and for decoding the information word from the selected coded word.

12. Device according to claim 12, wherein the second means include:

 - a first sub-circuit (DIST) for calculating the distances (D1, D2) between the received coded word (Lin) and the at least two coded words (L1, L2) of the configured sub-set;
 - a second sub-circuit (COMP) for comparing each other the calculated distances;
 - a third sub-circuit (SEL) for selecting from the at least two coded words (L1, L2) the coded word (Lout) having the minimum calculated distance.

13. Device according to claims 11 or 12, further including third means (ERR) for:

- comparing (CE-2, CE-3) the calculated distances respect to a pre-determined distance (N);
- in case at least one of the calculated distances is greater than the pre-determined distance, generating a signal (Val) for indicating that the decoded information word is not valid;
- in case the calculated distances are smaller or equal to the pre-determined distance, generating the signal (Val) for indicating that the decoded information word is valid.

**14.** Device according to claim 13, wherein the payload field carries a video signal.

**15.** Device according to any of claims 11 to 14, wherein the sub-set consists of two coded words.

**16.** Network element (NE-RX) including processing means (M2) adapted to receive a data packet (IP1, IP2), the processing means including a device according to any of claims 11 to 15, the data packet including an header field (Core header, PLI, cHEC) carrying the received coded word and including a payload field (Payload area), the received coded word indicating the coded length of the payload field of the received data packet, wherein the processing module is further adapted to extract (GFPD) the coded word from the received data packet.

**17.** Computer program comprising computer program code means adapted to perform all the steps of the method according to any of claims 1 to 10 when the program is run on a hardware of a network element.

**Amended claims in accordance with Rule 137(2) EPC.**

**1.** Method for transmitting traffic of higher layer client signals over a transport network, said method comprising:

a) adapting said traffic of higher layer signals to said transport network by encapsulating portions of said traffic in a payload field (Payload area) of a frame (IP1, IP2) and inserting in a header field (Core header, PLI, cHEC) of said frame (IP1, IP2) an information word which is indicative of a length of said payload field (Payload area) and which is selected from a set of coded words,
b) transmitting said frame (IP1, IP2) through said transport network, and
c) receiving said frame (IP1, IP2) from said transport network,
said method being **characterized in that**:

a') said step of inserting said information word in said header field (Core header, PLI, cHEC) comprises the step of inserting in said header field (Core header, PLI, cHEC) a first coded word (Lin) selected from a pre-configured sub-set of the set of the coded words, wherein the sub-set is configured to at least two coded words (L1, L2) having each other a distance higher than the minimum distance between the coded words of the set; and
b') the step of receiving said frame (IP1, IP2) comprises a
step of decoding said information word by:

b'1) extracting said first coded word (Lin); and
b'2) selecting (DIST, COMP, SEL) a second coded word (Lout) having the minimum distance (D1, D2) from the first coded word (Lin) from said pre-configured sub-set of the set of the coded words.

**2.** Method according to claim 1, wherein the payload field (Payload area) carries a video signal.

**3.** Method according to any of the previous claims, wherein the sub-set consists of two coded words (L1, L2).

**4.** Method according to any of the previous claims, further including the step of generating a signal (Val) indicating if the decoded information word is valid.

**5.** Method according to claims 3 or 4 when dependent on claim 2, wherein one (L1) of the two coded words (L1, L2) of the sub-set indicates that the data packet (IP1) has a zero-length payload and the other (L2) of the two coded words (L1, L2) of the sub-set indicates the coded length of the payload field carrying the video signal.

**6.** Method according to any of claims 2 to 5, wherein the received data packet further includes another header field (Payload header, Type, tHEC) carrying a third coded word indicating that the type of the payload field is the video signal, wherein the other header field is configured to the type indicating the video signal, the method further including the steps of:

- extracting the third coded word from the received data packet;
- detecting the number of errors affecting the third received coded word;
- discarding the third received coded word in case the number of errors is greater than a pre-defined number;
- assigning the other header field to the configured type indicating the video signal.

**7.** Method according to any of the previous claims, wherein the received data packet (IP1,IP2) is arranged into a Generic Framing Procedure frame and wherein the received coded word is the core header of the received GFP frame.

**8.** Method according to claim 7, wherein the other header field is the payload header of the Generic Framing Procedure frame.

**9.** Method according to any of claims 2 to 8, wherein the data packet is received from a radio link.

**10.** Communication system for transmitting traffic of higher layer client signals over a transport network, said communication system comprising:

- a transmitter for

- adapting said traffic to said transport network by encapsulating portions of said traffic in a payload field (Payload area) of a frame (IP1, IP2) and inserting in a header field (Core header, PLI, cHEC) of said frame (IP1, IP2) an information word which is indicative of a length of said payload field (Payload area) and which is selected from a set of coded words, and
- transmitting said frame (IP1, IP2) through said transport network, and

- a receiver for receiving said frame (IP1, IP2) from said transport network,

said communication system being **characterized in that**:

- said transmitter is further suitable for inserting said information word in said header field (Core header, PLI, cHEC) by inserting a first coded word (Lin) selected from a pre-configured subset of the set of the coded words, wherein the sub-set is configured to at least two coded words (L1, L2) having each other a distance higher than the minimum distance between the coded words of the set, and **in that**
- said receiver comprises a device (DECOD) to decode said information word, the device (DECOD) including first means (DIST, COMP, SEL) for selecting from the configured sub-set a second coded word (Lout) having the minimum distance from the first coded word (Lin).

**11.** System according to claim 10, wherein the first means include:

- a first sub-circuit (DIST) for calculating the distances (D1, D2) between the first coded word (Lin) and the at least two coded words (L1, L2) of the configured sub-set;
- a second sub-circuit (COMP) for comparing each other the calculated distances;
- a third sub-circuit (SEL) for selecting from the at least two coded words (L1, L2) the second coded word (Lout) having the minimum calculated distance.

**12.** System according to claims 10 or 11, further including second means (ERR) for:

- comparing (CE-2, CE-3) the calculated distances respect to a pre-determined distance (N);
- in case at least one of the calculated distances is greater than the pre-determined distance, generating a signal (Val) for indicating that the decoded information word is not valid;
- in case the calculated distances are smaller or equal to the pre-determined distance, generating the signal (Val) for indicating that the decoded information word is valid.

**13.** System according to claim 12, wherein the payload field carries a video signal.

**14.** System according to any of claims 10 to 13, wherein the sub-set consists of two coded words.

Fig.1

| Payload header |
| :---: |
| Payload information field |
| Payload FCS |

# Fig.2

| Type |
| :---: |
| tHEC |
| extension header field |
| eHEC |

# Fig.3

NE-TX

IP2

| (2) | PLI |
| (2) | cHEC |
| (2) | Type |
| (2) | tHEC |
| (188) | TS |
| (16) | RS |

NTWK

IP1

| (2) | PLI |
| (2) | cHEC |

NE-RX

Fig.4

Fig.5

Fig.6

**European Patent Office**

**EUROPEAN SEARCH REPORT**

Application Number

EP 07 29 0521

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,Y | ITU-T TELECOMMUNICATION STANDARDIZATION SECTOR OF ITU: "ITU-T Recommendation G.7041/Y.1303 (08/2005): Generic framing procedure (GFP)" ITU-T RECOMMENDATION G.7041/Y.1303, XX, XX, August 2005 (2005-08), pages 1-57, XP002363710 * paragraphs [06.1], [6.2.1]; figures 6-2,6-10 * | 1-17 | INV. H04L1/00 H03M13/09 |
| Y | ATSC: "ATSC Digital Television Standard Part 2 -RF/Transmission System Characteristics"[Online] 3 January 2007 (2007-01-03), pages 1-44, XP002443044 Retrieved from the Internet: URL:http://www.atsc.org/standards/a_53-Part-2-2007.pdf> [retrieved on 2007-07-18] * paragraph [6.4.1.2] * | 1-17 | |
| A | B. MCDANIEL: "An Algorithm for Error Correcting Cyclic Redundancy Checks" DR. DOBB'S PORTAL, [Online] 8 May 2003 (2003-05-08), XP002443045 Retrieved from the Internet: URL:http://www.ddj.com/dept/cpp/184401662> [retrieved on 2007-07-17] * the whole document * | | TECHNICAL FIELDS SEARCHED (IPC) H04L H03M |
| A | W. YUE, D. GUTIERREZ: "Ready for primetime: MSPPs can deliver digital video over existing networks"[Online] December 2003 (2003-12), XP002443046 Retrieved from the Internet: URL:http://lw.pennnet.com/articles/article_display.cfm?article_id=194655> [retrieved on 2007-07-18] * the whole document * | 1-17 | |

-/--

The present search report has been drawn up for all claims

| Place of search | Date of completion of the search | Examiner |
|---|---|---|
| The Hague | 18 July 2007 | Van Staveren, Martin |

**European Patent Office**

## EUROPEAN SEARCH REPORT

Application Number

EP 07 29 0521

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | S. GORSHE: "Master Transparent-Mode GFP: Part 1" COMMSDESIGN, [Online] November 2002 (2002-11), pages 1-3, XP002443047 Retrieved from the Internet: URL:http://i.cmpnet.com/commsdesign/csd/2002/sep02/sept02-feat2.pdf> [retrieved on 2007-07-18] * the whole document * ----- | 1-17 | |
| A | S. GORSHE: "Transparent-Mode GFP Tutorial: Part 2"[Online] November 2002 (2002-11), pages 1-5, XP002443048 Retrieved from the Internet: URL:http://i.cmpnet.com/commsdesign/csd/2002/sep02/trans-pt2-final.pdf> [retrieved on 2007-07-18] * the whole document * ----- | 1-17 | |
| | | | TECHNICAL FIELDS SEARCHED (IPC) |

The present search report has been drawn up for all claims

| Place of search | Date of completion of the search | Examiner |
|---|---|---|
| The Hague | 18 July 2007 | Van Staveren, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .......................................................................................................

& : member of the same patent family, corresponding document

EPO FORM 1503 03.82 (P04C01)